# FASCICULE DE BREVET EUROPEEN

(11) **EP 2 013 969 B1**
(45) Date de publication et mention de la délivrance du brevet: **09.12.2009**
(21) Numéro de dépôt: 07727423.1
(22) Date de dépôt: 28.03.2007
(51) Int. Cl.: H03G 3/30

(54) **DISPOSITIF ET PROCÉDÉ D'AMPLIFICATION DE SIGNAUX DE RADIOCOMMUNICATIONS**
EINRICHTUNG UND VERFAHREN ZUR VERSTÄRKUNG VON FUNKKOMMUNIKATIONSSIGNALEN
DEVICE AND METHOD FOR AMPLIFICATION OF RADIOCOMMUNICATION SIGNALS

(30) Priorité: 21.04.2006 FR 0651405
(43) Date de publication de la demande: 14.01.2009
(73) Titulaire: THALES, 92200 Neuilly sur Seine (FR)
(72) Inventeur: RODRIGUEZ, Raoul, 31150 Bruguieres (FR); AYOUAZ, Patrick, 31470 Saint Lys (FR); CHABBERT, Philippe, 31600 Saubens (FR); MAYNARD, Jean, 31520 Ramonville (FR); PEYRETAILLADE, Thierry, 31100 Toulouse (FR)
(74) Mandataire: Esselin, Sophie
(86) Numéro de dépôt international: PCT/EP2007/052950
(87) Numéro de publication internationale: WO 2007/122059

(56) Documents cités:
- DE-A1- 19 623 930
- JP-A- 57 030 429
- US-A1- 2003 055 590
- US-A1- 2006 006 940

## Description

La présente invention concerne un circuit de contrôle du gain d'un dispositif d'amplification de signaux de radiocommunications, un dispositif d'amplification muni d'un tel circuit de contrôle et un satellite comportant un tel dispositif d'amplification.

Il est connu de traiter des signaux de radiocommunications selon un premier mode amplifiant ces signaux avec un gain constant ou selon un second mode amplifiant ces signaux jusqu'à une puissance constante en sortie de l'amplificateur indépendamment de la puissance d'entrée de ces signaux.

Certains équipements de télécommunications, tels que des satellites, alternent ces deux modes d'amplification. Ainsi, des signaux de radiocommunications reçus par certains satellites peuvent être amplifiés selon le premier mode à gain constant, ce procédé étant dénommé par la suite FGM pour 'Fixe Gain Mode, ou selon le second mode à puissance de sortie constante, ce procédé étant dénommé par la suite ALC pour 'Automatic Level Control' en anglais.

US 2006/0006940 concerne un dispositif d'amplification ayant une pluralité de modes d'opération. DE 196 23 930 décrit un système d'amplificateurs, chaque amplificateur ayant un atténuateur réglable recevant des signaux de contrôle. JP 57030429 est relatif à un système de restitution automatique pour un régulateur de niveau automatique. US 2003/055590 décrit un amplificateur opérant dans un mode ALC ou dans un FGM.

La figure la représente schématiquement un dispositif 100 d'amplification permettant d'alterner les deux modes FGM ou ALC pour amplifier une puissance d'entrée Pᵢₙ d'un signal de radiocommunications jusqu'à une puissance de sortie Pₒᵤₜ.

A cet effet, ce dispositif 100 comprend une chaîne 101 d'amplificateurs 112 dont le gain est partiellement contrôlé par un contrôleur 113 de gain, le fonctionnement de ce contrôleur 113 étant déterminé par une consigne qui varie selon le mode d'amplification du dispositif 100. Dans cet exemple, cette consigne est une tension Vₐₜₜ.

Un circuit 104 de contrôle délivre une telle consigne, ou tension, Vₐₜₜ de valeur V_{fgm} fixe transmise par une source REF FGM, pour obtenir un gain constant dans la chaîne 101 d'amplificateurs 102, ou de valeur V_{alc} variable, pour obtenir une puissance Pₒᵤₜ constante en sortie du dispositif 100.

Dans ce dernier cas, la consigne V_{alc} variable est obtenue en sortie d'un régulateur 106 formant une boucle d'asservissement pour réguler cette tension en fonction de l'écart entre la puissance Pₒᵤₜ de sortie souhaitée et une consigne REF ALC du régulateur 106 transmise par un dispositif non représenté. Pour ce faire, ce régulateur 106 peut comprendre un amplificateur opérationnel 141 - et d'autres composants électroniques non représentés - tandis que la mesure de la puissance Pₒᵤₜ de sortie s'effectue à travers un détecteur 108 corrigeant les effets de la température sur la mesure.

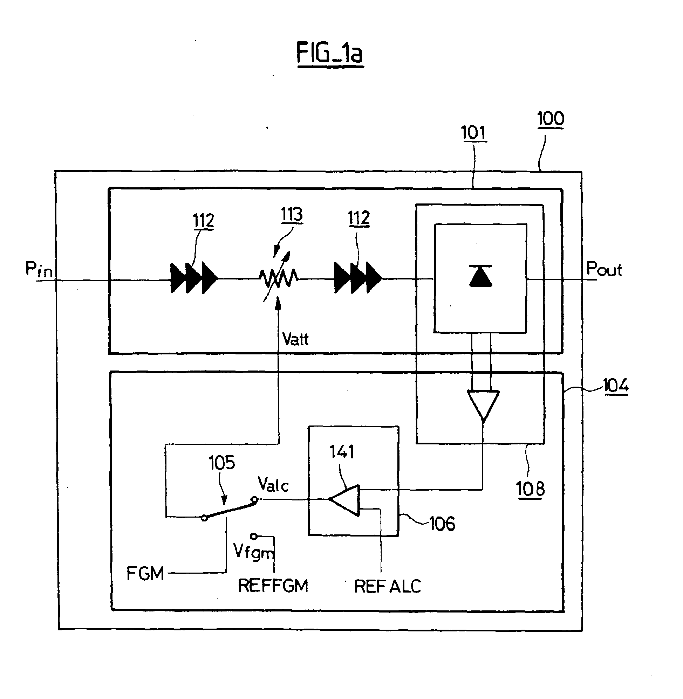

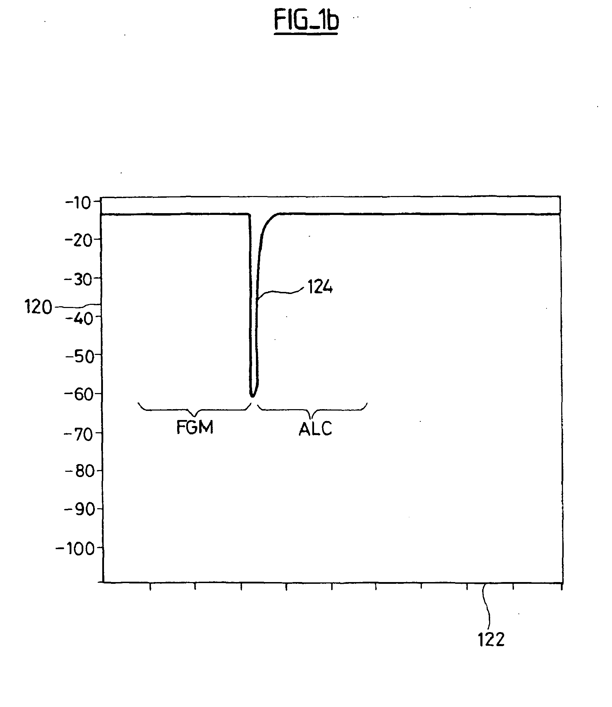

Un tel dispositif 100 présente de fortes variations du gain d'amplification et de puissance Pₒᵤₜ de sortie lors du passage d'un mode FGM à un mode ALC comme illustré sur la figure 1b qui représente la variation (axe des ordonnées 120, en dBm) de la puissance de sortie Pₒᵤₜ d'un dispositif 100 en fonction du temps (axe des abscisses 122, en ms) lors d'un changement 124 du mode d'amplification pour le dispositif 100.

De fait, lorsque le dispositif 100 est en mode FGM, le régulateur 106 fournit une tension maximale V_{alcmax} pour amener la puissance de sortie Pₒᵤₜ à une puissance constante de telle sorte que, lors du basculement en mode ALC par un basculement d'un commutateur 105, la tension de commande Vₐₜₜ atteint cette tension V_{alcmax} maximale avant de tendre vers une valeur propre à un point de fonctionnement du circuit.

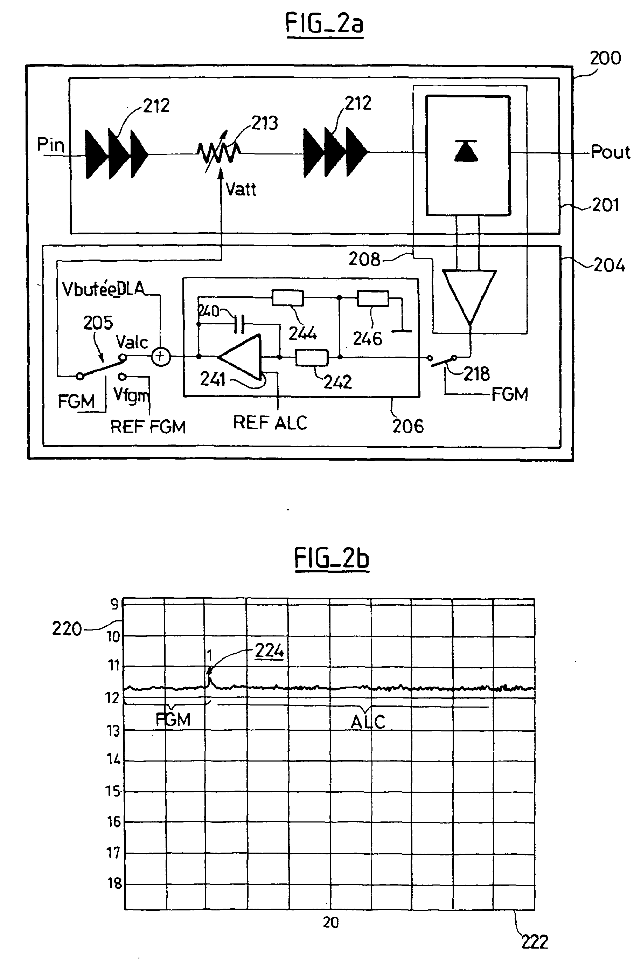

Une telle variation de puissance est problématique car elle risque d'entraîner des pertes de signaux, notamment entre un satellite et une station au sol. De ce fait, un circuit 204 (figure 2a) contrôlant une chaîne 201 d'amplificateurs 212 peut comprendre des moyens pour que la tension V_{alc} en sortie d'un régulateur 206 soit fixée à une valeur fixe et proche d'une valeur V_{fgm} de consigne prédéterminée et propre à un mode FGM.

En considérant un régulateur 206 comprenant un amplificateur opérationnel 241, ce résultat est atteint en intégrant un jeu de résistances 244 et 246 fixant la tension de sortie du régulateur 206 à une valeur précise lorsque le dispositif 200 fonctionne en mode FGM, une capacité 240 et une résistance 242 formant un élément intégrateur avec l'amplificateur 241 pour fournir une consigne variable à partir de la consigne REF ALC en mode ALC.

Une telle configuration permet d'obtenir, comme montré sur la figure 2b, une variation de puissance Pₒᵤₜ amplifiée, relativement limitée lors d'un changement 224 d'un mode FGM à un mode ALC (axe des ordonnées 220, en dBm) en fonction du temps (axe des abscisses 222, en ms).

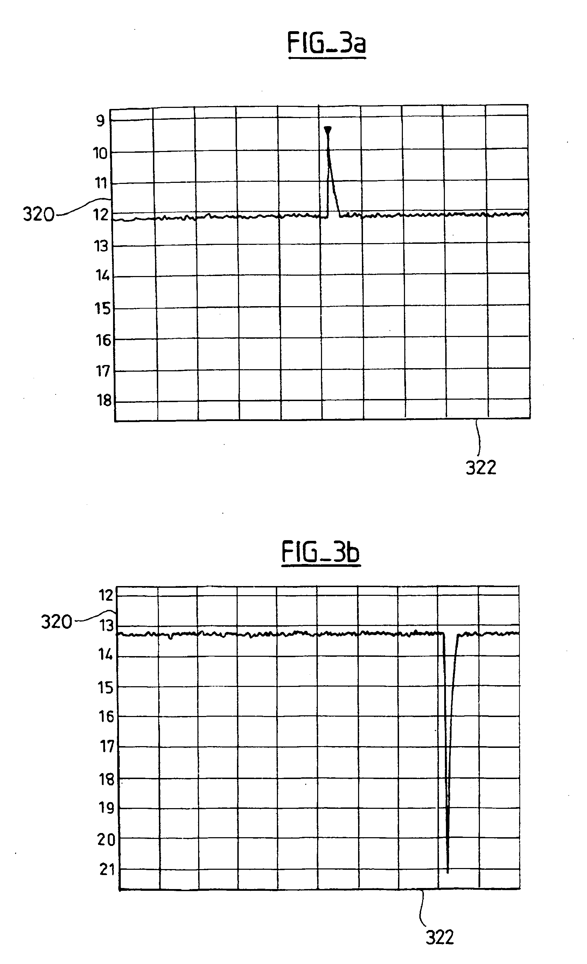

La présente invention résulte d'une constatation propre à l'invention selon laquelle la continuité de ces basculements n'est obtenue que pour des conditions données, notamment en terme de température, de puissance et/ou de fréquence de fonctionnement de la chaîne 201 d'amplificateurs 212, comme montré sur les figures 3a et 3b qui représentent des puissances de sortie (axe des ordonnées 320, en dBm) mesurées pour le circuit 200 en fonction du temps (axe des abscisses 322, en ms) avec des variations de températures respectives de + 41°C et de - 36°C, c'est-à-dire des variations de l'ordre de +/-40°C par rapport aux mesures représentées à la figure 2b.

C'est pourquoi, la présente invention concerne un circuit de contrôle du gain d'un dispositif d'amplification de signaux de radiocommunications transmis par une chaîne d'amplificateurs munie d'un contrôleur de gain, le circuit de contrôle étant apte à délivrer une consigne de valeur constante pour obtenir un gain constant, ou de valeur variable, le circuit de contrôle comprenant un premier régulateur formant, dans une première position d'amplification à puissance amplifiée constante, une boucle de rétroaction sur la chaîne à partir d'un détecteur de la puissance amplifiée et délivrant la consigne de valeur variable à partir d'une mesure de la fonction délivrée, **caractérisé en ce qu'**il comprend un second régulateur formant, en mode d'amplification à gain constant, une boucle de rétroaction avec le premier régulateur afin de maintenir une consigne transmise par ce premier régulateur à une valeur proche de la consigne de valeur constante.

En maintenant la consigne fourni par le premier régulateur proche de la consigne de valeur constante, le circuit de contrôle présente l'avantage d'effectuer des transitions d'un mode FGM vers un mode ALC présentant des variations de puissance de sortie très limitées, voire inexistantes, indépendamment des variations des conditions de température, de puissance et/ou de fréquence de l'amplificateur concerné.

De fait, l'invention assure que la consigne transmise par le régulateur, en mode ALC, soit proche de la consigne en mode FGM indépendamment des variations dues aux conditions de fonctionnement de l'amplificateur. Dès lors, le passage de la consigne FGM à la consigne ALC s'effectue avec continuité et, de façon corollaire, avec des variations de gain limitées.

Dans une réalisation, le circuit de contrôle comprend un commutateur qui relie le premier régulateur au second régulateur ou au détecteur de puissance amplifiée en fonction de l'amplification effectuée. Ainsi, un simple commutateur du signal transmis au premier régulateur permet de basculer le fonctionnement de ce dernier d'une boucle de rétroaction avec le second régulateur - pour fournir une consigne proche de la consigne de valeur constante - à une boucle de rétroaction avec la chaîne des amplificateur - pour fournir une puissance amplifiée constante.

Selon une réalisation, le circuit de contrôle comprend un second commutateur qui relie le contrôleur au premier régulateur ou à la source de consigne constante en fonction de l'amplification effectuée.

Dans une réalisation, au moins un régulateur comprend un amplificateur opérationnel, ce qui permet d'obtenir des régulateurs fiables et à faible coût.

Selon une réalisation, le premier et le second régulateur comprenant un amplificateur opérationnel, chaque amplificateur opérationnel est associé à au moins une résistance et à une capacité telles que le temps de réponse du premier régulateur soit supérieur au temps de réponse du second régulateur.

Dans une réalisation, le premier régulateur est associé à des moyens permettant d'augmenter son temps de réponse, ce qui permet de filtrer d'éventuels signaux parasites.

La présente invention concerne également un dispositif d'amplification de signaux de radiocommunications transmis dans une chaîne d'amplificateurs munie d'un contrôleur de gain **caractérisé en ce qu**'il comporte un circuit de contrôle du gain de la chaîne d'amplificateurs.

L'invention concerne aussi un satellite comportant un tel dispositif d'amplification de signaux de radiocommunications.

D'autres caractéristiques et avantages de l'invention apparaîtront avec la description d'une réalisation de l'invention décrite ci-dessous, à titre illustratif et non limitatif, en faisant référence aux figures ci-jointes sur lesquelles :
- les figures 1 a et 1 b, déjà décrites, représentent respectivement un premier dispositif d'amplification et son gain pour différents modes d'amplification,
- les figures 2a et 2b, déjà décrites, représentent respectivement un second dispositif d'amplification et son gain pour différents modes d'amplification,
- les figures 3a et 3b représentent le gain du dispositif d'amplification décrit à la figure 2a lorsque sa température varie,
- les figures 4a et 4b représentent respectivement un dispositif d'amplification conforme à l'invention et son gain pour différents modes d'amplification, et
- la figure 5 représente le gain d'un dispositif conforme à l'invention.

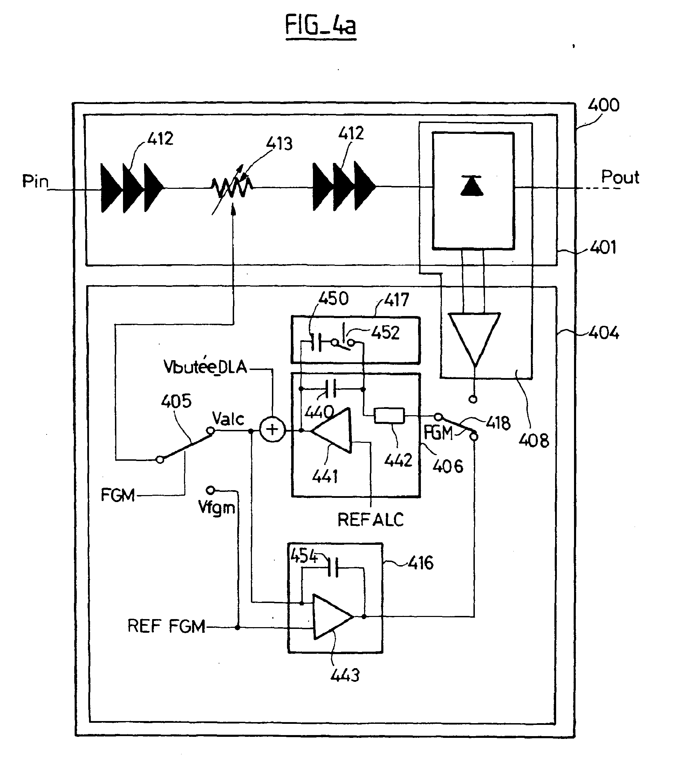

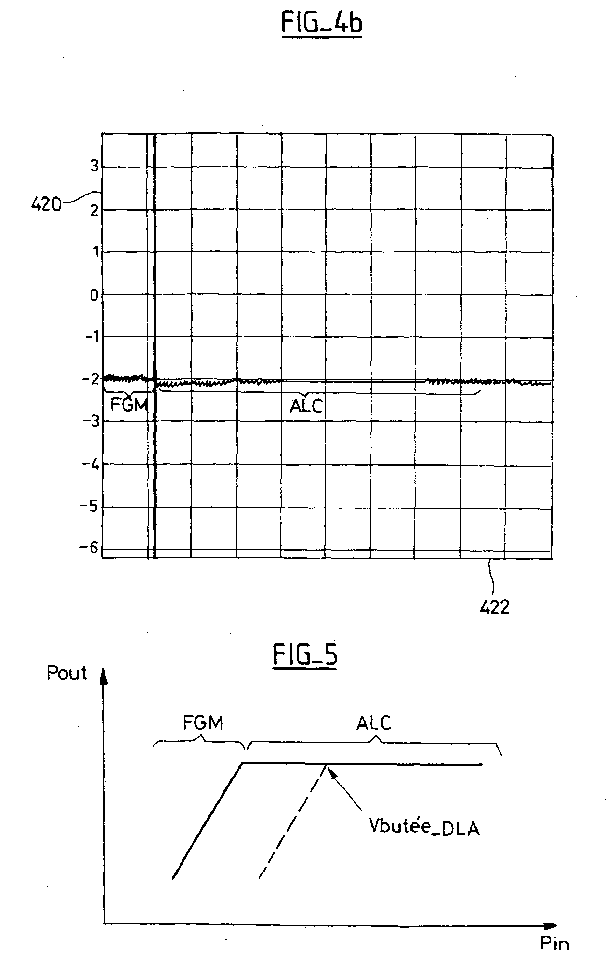

Comme montré sur la figure 4a, un dispositif 400 d'amplification de signaux de radiocommunications implémentant l'invention comprend une chaîne 401 d'amplificateurs 412 dont le gain est contrôlé en partie par une consigne d'amplification Vₐₜₜ, transmise par un circuit 404 de contrôle à un contrôleur 413 de gain. Cette consigne Vₐₜₜ peut alterner entre deux valeurs :
- Soit une valeur constante V_{fgm}, auquel cas la chaîne 401 d'amplificateurs 412 effectue une amplification à gain constant du type FGM,
- Soit une valeur variable V_{alc}, auquel cas la chaîne 401 d'amplificateurs 412 effectue une amplification du type ALC à puissance de sortie constante.

Pour mettre en oeuvre ce deuxième mode d'amplification, le circuit 400 comprend un premier régulateur 406 délivrant une consigne de valeur V_{alc} variable à partir d'un asservissement utilisant la mesure de la puissance Pₒᵤₜ de sortie de l'amplificateur à l'aide d'un détecteur 408 compensé en température.

Conformément à l'invention, un second régulateur 416 régule le premier régulateur 406 lorsque le dispositif 400 fonctionne en mode d'amplification à gain constant FGM pour que ce dernier fournisse de façon automatique et dynamique une consigne proche ou égale de la consigne V_{fgm} en suivant les éventuelles modifications de cette consigne V_{fgm} constante dues aux variations d'un ou plusieurs paramètres de fonctionnement du dispositif tels que sa fréquence ou sa température.

Pour cela, ce second régulateur 416 effectue un asservissement de la consigne de valeur variable V_{alc} transmise par le premier régulateur à partir de la consigne de valeur constante V_{fgm} mise en oeuvre par le circuit 400.

Un tel asservissement peut être effectué en reliant, en mode FGM, le second régulateur 416 au premier régulateur 406 afin que ces régulateurs 406 et 416 forment une boucle dont l'équilibre impose une consigne V_{alc} en sortie du régulateur 406 correspondant à la valeur de la consigne V_{fgm} constante.

En mode ALC, une telle boucle de rétroaction ne doit pas être mise en oeuvre afin que le premier régulateur puisse modifier son signal de sortie du régulateur 406 à une valeur de consigne V_{alc} permettant d'obtenir une puissance Pₒᵤₜ de sortie constante.

Ces résultats sont atteints grâce à un commutateur 418 qui relie une entrée du premier régulateur 406, dans une position, à la sortie du second régulateur 416 ou, dans une autre position, à la sortie du détecteur 408.

En considérant que le premier régulateur 406 et le second régulateur 416 comprennent respectivement un amplificateur opérationnel 441 ou 443, il apparaît que l'utilisation de composants électroniques simples tels qu'une capacité 440 ou 454 et une résistance 442 permettent de former le régulateur 406 ou le régulateur 416.

Seuls quelques composants ont été représentés par soucis de clarté compte tenu du fait que le choix de leurs valeurs permet de déterminer le temps de réponse de chaque régulateur. Ainsi, le premier régulateur 406 est associé à une capacité 440 de 100 nF et à une résistance 442 dont la valeur varie entre 10kOhm et 1MOhm selon la bande passante désirée, par exemple de 250kOhm.

Pour que le temps de réponse du régulateur 416 soit inférieur au temps de réponse du second régulateur 406, on peut associer à ce second régulateur 416 une capacité 454 de 1 microF et une résistance - non représentée - de 3.16 kOhm. Par ailleurs, la constante de temps du régulateur 406 peut être modifiée à l'aide d'une seconde capacité 450 de 1 microF pouvant être mise en parallèle avec la première capacité 440 grâce à un interrupteur 452 à l'aide d'un dispositif 417.

Une telle augmentation du temps de réponse permet de filtrer, par exemple au moment du changement de mode FGM vers ALC, des décalages du circuit 404 de contrôle ou du dispositif 400 d'amplification, dus aux paramètres de fonctionnement du dispositif tels que sa fréquence ou sa température, et à son environnement fin de vie tel que les charges cumulées par irradiation ou son vieillissement.

Un dispositif 400 conforme à l'invention peut être utilisé comme DLA pour 'Driver Limiter Amplifier', c'est-à-dire pour effectuer l'amplification de signaux reçus par un relais spatial tel qu'un satellite qui peut ainsi modifier son mode d'amplification comme montré sur la figure 5 qui représente la puissance de sortie Pₒᵤₜ (axe des ordonnées) en fonction de la puissance d'entrée Pᵢₙ (axe des abscisses) en fonction du mode FGM ou ALC utilisés.

A titre d'exemple, ces valeurs de puissances varient typiquement dans un satellite entre -20 et - 60 dBm pour Pᵢₙ et -20dBm à + 10 dBm pour Pₒᵤₜ, les signaux amplifiés ayant une fréquence comprise entre 100 MHz et 100 GHz.

La figure 5 montre la variation possible du point 504 de décrochage de la boucle ALC en fonction de la puissance d'entrée Pin. Ce décrochage de la boucle peut être contrôlé en mode ALC par une tension Vbutée_DLA, dont la source est représentée sur la figure 4a, afin d'obtenir en mode ALC un contrôle de la chaîne 401 similaire à un mode FGM sans avoir basculé en mode FGM.

La présente invention est susceptible de nombreuses variantes. Notamment, les régulateurs 406 et 416 peuvent être obtenues par des microcomposants programmables dont la fonction de transfert permet un fonctionnement équivalent au fonctionnement décrit ci-dessus des régulateurs 406 et 416.

## Revendications

1. Circuit (404) de contrôle du gain d'un dispositif d'amplification (401) de signaux de radiocommunications transmis par une chaîne (401) d'amplificateurs (412) munie d'un contrôleur (413) de gain, le circuit de contrôle (404) étant apte à délivrer une consigne (Vₐₜₜ) de valeur constante (V_{fgm}) pour obtenir un gain constant, ou de valeur variable (V_{alc}), le circuit de contrôle (404) comprenant un premier régulateur (406) formant, dans une première position (ALC) d'amplification à puissance (Pₒᵤₜ) amplifiée constante, une boucle de rétroaction sur la chaîne (401) à partir d'un détecteur (408) de la puissance amplifiée (Pₒᵤₜ) et délivrant la consigne de valeur variable (V_{alc}) à partir d'une mesure d'une fonction délivrée à la sortie de la chaine (Pₒᵤₜ), **caractérisé en ce qu'**il comprend un second régulateur (416) formant, en mode d'amplification à gain constant (FGM), une boucle de rétroaction avec le premier régulateur (406) afin de maintenir une consigne transmise par ce premier régulateur à une valeur proche de la consigne de valeur constante (V_{fgm}).

2. Circuit selon la revendication 1 dans lequel un commutateur (418) relie le premier régulateur (406) au second régulateur (416) ou au détecteur (408) de puissance amplifiée (Pₒᵤₜ) en fonction de l'amplification (FGM, ALC) effectuée.

3. Circuit selon l'une quelconques des revendications 1 ou 2 dans lequel un second commutateur (405) relie le contrôleur (413) au premier régulateur (406) ou à une source de consigne constante (V_{fgm}) en fonction de l'amplification (FGM, ALC) effectuée.

4. Circuit selon l'une quelconque des revendications 1 à 3 dans lequel au moins un régulateur (406, 416) comprend un amplificateur opérationnel (441, 443).

5. Circuit selon la revendication 4, dans lequel le premier et le second régulateur comprennent un amplificateur opérationnel, et dans lequel chaque amplificateur opérationnel (441, 443) est associé à au moins une résistance (442) et à une capacité (440, 454) telles que le temps de réponse du premier régulateur (406) soit supérieur au temps de réponse du second régulateur (416).

6. Circuit selon l'une quelconque des revendications précédentes dans lequel le premier régulateur (406) est associé à des moyens (417) permettant d'augmenter son temps de réponse.

7. Dispositif (400) d'amplification de signaux de radiocommunications transmis par une chaîne (401) d'amplificateurs (412) munie d'un contrôleur (413) de gain, **caractérisé en ce qu'**il comporte un circuit (404) de contrôle du gain de la chaîne (401) d'amplificateurs (412) selon l'une quelconque des revendications précédentes.

8. Satellite **caractérisé en ce qu'**il comporte un dispositif (400) d'amplification de signaux de radiocommunications selon la revendication 7.

## Claims

1. Circuit (404) for controlling the gain of a device (401) for amplifying radiocommunication signals transmitted by a string (401) of amplifiers (412) furnished with a gain controller (413), the control circuit (404) being capable of delivering a setpoint (Vₐₜₜ) of constant value (V_{fgm}) in order to obtain a constant gain or of variable value (V_{alc}), the control circuit (404) comprising a first regulator (406) forming, in a first amplification position (ALC) at a constant amplified power (Pₒᵤₜ), a feedback loop on the string (401) based on a detector (408) of the amplified power (Pₒᵤₜ) and delivering the setpoint of variable value (V_{alc}) based on a measurement of a function delivered at the output of the string (Pₒᵤₜ), **characterized in that** it comprises a second regulator (416) forming, in constant gain amplification mode (FGM) a feedback loop with the first regulator (406) so as to hold a setpoint transmitted by this first regulator at a value close to the setpoint of constant value (V_{fgm}).

2. Circuit according to Claim 1, wherein a switch (418) connects the first regulator (406) to the second regulator (416) or to the detector (408) of amplified power (Pₒᵤₜ) as a function of the amplification (FGM, ALC) produced.

3. Circuit according to either of Claims 1 and 2, wherein a second switch (405) connects the controller (413) to the first regulator (406) or to a source of constant setpoint (V_{fgm}) as a function of the amplification (FGM, ALC) produced.

4. Circuit according to any one of Claims 1 to 3, wherein at least one regulator (406, 416) comprises an operational amplifier (441, 443).

5. Circuit according to Claim 4, wherein the first and the second regulator comprise an operational amplifier, and wherein each operational amplifier (441, 443) is associated with at least one resistor (442) and with one capacitor (440, 454) such that the response time of the first regulator (406) is greater than the response time of the second regulator (416).

6. Circuit according to any one of the preceding claims, wherein the first regulator (406) is associated with means (417) making it possible to increase its response time.

7. Device (400) for amplifying radiocommunication signals transmitted by a string (401) of amplifiers (412) furnished with a gain controller (413), **characterized in that** it comprises a circuit (404) for controlling the gain of the string (401) of amplifiers (412) according to any one of the preceding claims.

8. Satellite **characterized in that** it comprises a device (400) for amplifying radiocommunication signals according to Claim 7.

## Patentansprüche

1. Schaltung (404) zum Steuern der Verstärkung einer Verstärkungsvorrichtung (401) für Funkkommunikationssignale, die durch eine Kette (401) von Verstärkern (412) übertragen werden, die mit einer Verstärkungssteuereinheit (413) versehen ist, wobei die Steuerschaltung (404) dazu ausgelegt ist, eine Stellgröße (Vₐₜₜ) mit konstantem Wert (V_{fgm}), um eine konstante Verstärkung zu erhalten, oder mit variablem Wert (V_{alc}) zu liefern, wobei die Steuerschaltung (404) einen ersten Regulierer (406) enthält, der in einer ersten Verstärkungsposition (ALC) mit konstanter verstärkter Leistung (Pₒᵤₜ) anhand eines Detektors (408) für die verstärkte Leistung (Pₒᵤₜ) eine Rückkopplungsschleife für die Kette (401) bildet und die Stellgröße mit variablem Wert (V_{alc}) anhand einer Messung einer am Ausgang der Kette gelieferten Funktion (Pₒᵤₜ) liefert, **dadurch gekennzeichnet, dass** sie einen zweiten Regulierer (416) enthält, der in der Verstärkungsbetriebsart mit konstanter Verstärkung (FGM) eine Rückkopplungsschleife mit dem ersten Regulierer (406) bildet, um eine von diesem ersten Regulierer übertragene Stellgröße auf einem Wert in der Nähe der Stellgröße mit konstantem Wert (V_{fgm}) zu halten.

2. Schaltung nach Anspruch 1, wobei ein Kommutator (418) den ersten Regulierer (406) in Abhängigkeit von der bewirkten Verstärkung (FGM, ALC) mit dem zweiten Regulierer (416) oder mit dem Detektor (408) für die verstärkte Leistung (Pₒᵤₜ) verbindet.

3. Schaltung nach einem der Ansprüche 1 oder 2, wobei ein zweiter Kommutator (405) die Steuereinheit (413) in Abhängigkeit von der bewirkten Verstärkung (FGM, ALC) mit dem ersten Regulierer (406) oder mit einer Quelle für die konstante Stellgröße (V_{fgm}) verbindet.

4. Schaltung nach einem der Ansprüche 1 bis 3, wobei wenigstens ein Regulierer (406, 416) einen Operationsverstärker (441, 443) enthält.

5. Schaltung nach Anspruch 4, wobei der erste und der zweite Regulierer einen Operationsverstärker enthalten und wobei jeder Operationsverstärker (441, 443) wenigstens einem Widerstand (442) und einer Kapazität (440, 454) zugeordnet ist, derart, dass die Ansprechzeit des ersten Regulierers (406) größer als die Ansprechzeit des zweiten Regulierers (416) ist.

6. Schaltung nach einem der vorhergehenden Ansprüche, wobei der erste Regulierer (406) Mitteln (417) zugeordnet ist, die die Erhöhung seiner Ansprechzeit ermöglichen.

7. Vorrichtung (400) zum Verstärken von Funkkommunikationssignalen, die durch eine Kette (401) von Verstärkern (412) übertragen werden, die mit einer Verstärkungssteuereinheit (413) versehen ist, **dadurch gekennzeichnet, dass** sie eine Schaltung (404) zum Steuern der Verstärkung der Kette (401) von Verstärkern (412) nach einem der vorhergehenden Ansprüche enthält.

8. Satellit, **dadurch gekennzeichnet, dass** er eine Vorrichtung (400) zum Verstärken von Funkkommunikationssignalen nach Anspruch 7 enthält.
